(19) Europäisches Patentamt
European Patent Office
Office européen des brevets

(11) **EP 2 179 073 B1**

(12) **EUROPÄISCHE PATENTSCHRIFT**

(45) Veröffentlichungstag und Bekanntmachung des Hinweises auf die Patenterteilung:
**17.11.2010 Patentblatt 2010/46**

(21) Anmeldenummer: **08756841.6**

(22) Anmeldetag: **26.06.2008**

(51) Int Cl.:
*C23C 16/30* (2006.01)   *C23C 16/36* (2006.01)
*C22C 29/02* (2006.01)   *C22C 29/16* (2006.01)

(86) Internationale Anmeldenummer:
**PCT/AT2008/000231**

(87) Internationale Veröffentlichungsnummer:
**WO 2009/003206 (08.01.2009 Gazette 2009/02)**

(54) **Al-Ti-Ru-N-C HARTSTOFFSCHICHT**

Al-Ti-Ru-N-C HARD MATERIAL COATING

REVÊTEMENT DE MATÉRIAU DUR EN AL-TI-RU-N-C

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **29.06.2007 AT 4082007 U**

(43) Veröffentlichungstag der Anmeldung:
**28.04.2010 Patentblatt 2010/17**

(73) Patentinhaber: **Ceratizit Austria Gesellschaft M.B.H.**
**6600 Reutte (AT)**

(72) Erfinder: **KATHREIN, Martin**
**A-6600 Reutte (AT)**

(56) Entgegenhaltungen:
**WO-A-2006/023222      JP-A- 8 199 340**
**JP-A- 8 199 341      JP-A- 8 209 332**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 179 073 B1

**Beschreibung**

Die Erfindung betrifft eine ein- oder mehrlagige nitridische oder karbonitridische Hartstoffschicht, die Al und Ti enthält.

Zur Erhöhung der Verschleißbeständigkeit werden auf verschleißbeanspruchten Körpern, insbesondere Verschleißteilen und Werkzeugen, hoch verschleißfeste Hartstoffschichten aufgebracht. Diese Schichten weisen Härtewerte üblicherweise im Bereich von 15 bis über 40 GPa auf. Zu den bewährten Hartstoffen zählen Karbide, Karbonitride, Nitride und Oxide, die oft als sich ergänzende Schichten in lagenweiser Anordnung gemeinsam zur Anwendung gelangen. Dabei werden Schichten abwechselnd aus unterschiedlichen Hartstoffen ausgeführt, um den verschiedenartigen Anforderungen hinsichtlich Haftung, Verschleiß und Zähigkeit gerecht zu werden. Als Substratkörper werden verschleißbeständige Werkstoffe, wie beispielsweise Hartmetalle, Cermet-Werkstoffe, Hartstoffe und Werkzeugstähle, eingesetzt.

Für viele Anwendungen haben sich $(Al_xTi_{1-x})(N_yC_{1-y})$ Schichten bewährt, die ausgezeichnete Verschleißeigenschaften mit hoher Oxidationsbeständigkeit kombinieren. Eine Schicht kubischer Kristallstruktur mit der Zusammensetzung $(Al_xTi_{1-x})(N_yC_{1-y})$ mit $0,56 \leq x \leq 0,75$; $0,6 \leq y \leq 1$ ist beispielsweise in der JP 2644710 beschrieben. Die Zugabe von Al zu TiN erhöht die Schichthärte und verbessert die Oxidationsbeständigkeit. Bei $x > 0,75$ sinkt die Schichthärte durch die Bildung hexagonaler Phase. Bei $x < 0,56$ fällt die Oxidationsstarttemperatur unter 800°C.

$(Al_xTi_{1-x})(N_yC_{1-y})$ Schichten können mittels physikalischer (PVD) oder chemischer Gasabscheidung (thermisches CVD, PACVD) hergestellt werden. Ein bevorzugtes PVD-Verfahren ist das Magnetron-Sputtern. Dabei werden metallische Al-Ti-Targets, die legiert oder als Verbundwerkstoff-Target vorliegen können, unter Verwendung von reaktiven Gasen zerstäubt und so $(Al_xTi_{1-x})(N_yC_{1-y})$ abgeschieden. Die sich bildenden $(Al_xTi_{1-x})(N_yC_{1-y})$ Phasen sind im Regelfall metastabil und bilden im Temperaturbereich zwischen 600°C und 1.000°C kohärente Ausscheidungen, wodurch eine Selbsthärtung während des Einsatzes bei hohen Temperaturen realisiert werden kann. Die Zusammensetzung der abgeschiedenen Schicht wird überwiegend von der Zusammensetzung des Sputtertargets bestimmt. Zusätzlich kann die Schicht noch weitere Bestandteile enthalten, wie beispielsweise Anteile eines Prozessgases, Verunreinigungen oder andere Beimischungen.

Durch Zulegieren von weiteren Elementen, der Abscheidung von Viellagenschichten und / oder durch gezielte Einstellung der Prozessparameter, beispielsweise der Biasspannung, kann die Schicht hinsichtlich struktureller, tribologischer und daraus resultierender Zerspanungseigenschaften optimiert werden. Es wird dabei nach Möglichkeit versucht, den hexagonalen Strukturanteil im Zweiphasensystem fcc(TiAl) N + hcp(AlTi) N gering zu halten.

So ist beispielsweise die Zugabe von Si in der US 5 558 653, die Zugabe von Ca, Dy, Nd, Ce, Sr in der JP 08-199340, von Y in der JP 08-199341 und Zr, Hf, V, Nb, Ta, Cr, Mo, W in der DE 36 11 492 beschrieben.

Den immer größer werdenden Anforderungen in Hinblick auf Verschleißbeständigkeit und Duktilität, Eigenschaften die wiederum die Werkzeugstandzeit bestimmen, werden die zuvor genannten Schichtsysteme in vielen Anwendungsfällen nicht mehr gerecht.

Es ist daher Aufgabe der vorliegenden Erfindung, dieser Forderung nach verbesserter Verschleißbeständigkeit, insbesondere bei sehr anspruchsvollen tribologischen Beanspruchungskollektiven, beispielsweise mit hoch abrasiven Gegenwerkstoffen oder hohen Temperaturen an den Schneidkanten von Schneideinsätzen, und der Forderung nach verbesserter Prozesssicherheit der Werkzeuge durch hohe Stabilität gegen Einkerbung und Ausbruch der Schneidkanten nachzukommen.

Die Aufgabe wird durch die Merkmale des unabhängigen Anspruchs gelöst. Die Hartstoffschicht kann dabei ein- oder mehrlagig ausgeführt sein.

Zumindest eine Schichtlage weist die Zusammensetzung $(Al_xTi_yRu_zMe_v)(N_aC_{1-a})$ auf, mit

$$0,45 \leq x \leq 0,75;$$

$$0,2 \leq y \leq 0,55;$$

$$0,001 \leq z \leq 0,1;$$

$$0 \leq v \leq 0,2$$

und

$$0,8 \leq a \leq 1,1.$$

Me ist dabei zumindest ein Element der Gruppe Si, B, W, Mo, Cr, Ta, Nb, V, Hf und Zr. Werden mehrere Elemente aus dieser Gruppe ausgewählt, so stellt v den Summengehalt dieser Elemente dar. Dass die Schicht (x + y + z + v) Werte zwischen 0,9 und 1,1 und a Werte von 0,8 bis bis 1,0 aufweisen kann, bedeutet, dass auch Nitride und Carbonitride mit von der stöchiometrischen Zusammensetzung leicht abweichenden Werten, die auch prozessbedingt auftreten können, die erfindungsgemäßen Eigenschaften aufweisen. Die besten Resultate konnten mit (x + y + z + v) = 1 erzielt werden.

Erfindungsgemäß werden die metallischen Anteile von Titan- und/oder Aluminium-Atomen in der AlTiN- oder AlTiNC-Matrix durch bis zu 10 At.% Ruthenium ersetzt.

Untersuchungen zeigten dabei, dass Ruthenium keine nitridischen, metallischen oder intermetallischen Phasen oder Verbindungen bildet.

Durch Variation des Ruthenium-Gehaltes bei konstantem Verhältnis von Al : (Ti+Ru) = 2 : 1 konnte festgestellt werden, dass mit steigendem Ruthenium-Gehalt eine Verschiebung der kubischen Vorzugsorientierung von (200) zu (111) auftritt. Ebenfalls konnte eine Aufweitung des Atomgitters in (200) Orientierung an Hand des FWHM-Wertes (full width at half maximum) beobachtet werden. Dies weist auf eine zumindest teilweise Zwangslösung der Ruthenium-Atome im AlTi(Me)N bzw. AlTi(Me)NC Gitter hin.

Durch Zugabe von Ruthenium wird die Warmhärte, speziell im Temperaturbereich > 700°C, verbessert. Dies ist vermutlich auf eine verstärkte Ausscheidung von AlN zurückzuführen. Die kubische Phase konnte auch bei Einsatztemperaturen von 900°C noch nachgewiesen werden. Es tritt damit auch eine Verschiebung des fcc / hcp Phasenübergangs auf. Damit behält die Hartstoffschicht auch bei hohen Einsatztemperaturen ihre Abrasionsbeständigkeit, was insbesondere für den Einsatz in Schneidwerkzeugen von großer Bedeutung ist. Zudem wird das Oxidationsverhalten der Hartstoffschicht durch die Ruthenium-Zugabe positiv beeinflusst.

Ist der Ruthenium-Gehalt zu gering (z < 0,001), kann keine ausreichende Wirkung mehr festgestellt werden. Bei hohen Ruthenium-Gehalten (z > 0,1) sinkt die Raumtemperaturhärte durch Ausbildung von hexagonaler Phase. Zudem sind derart hohe Ruthenium-Gehalte auf Grund des hohen Ruthenium-Preises wirtschaftlich nicht sinnvoll. Der bevorzugte Ruthenium-Gehalt liegt bei $0,005 \leq z \leq 0,06$.

Liegt x unter 0,45 ist keine ausreichende Oxidationsbeständigkeit zu beobachten.

Bei x > 0,75 sinkt die Schichthärte durch Ausbildung hexagonaler Phasenbestandteile auf ein unzulässig niedriges Niveau. Liegt y unter 0,2 ist die Schichthärte zu niedrig. Bei y > 0,55 ist wiederum keine ausreichende Oxidationsbeständigkeit zu beobachten.

Die Hartstoffschicht kann aus einer oder vielen Schichtlagen unterschiedlicher Zusammensetzung und / oder Struktur aufgebaut sein. Zumindest eine Schichtlage weist dabei die erfindungsgemäße Zusammensetzung auf.

Es hat sich gezeigt, dass die Elemente Silizium, Bor, Wolfram, Molybdän, Chrom, Tantal, Niob, Vanadin, Hafnium und Zirkon in Ruthenium-haltigen AlTiN- bzw. AlTiNC-Schichten einen ähnlichen Effekt wie in Ruthenium-freien Schichten bewirken. Der optimale Silizium- und Bor-Gehalt liegt dabei bezogen auf den metallischen Anteil bei 0,1 bis 1 At.%, der optimale Chrom-, Wolfram- und Molybdän-Gehalt bei 1 bis 10 At.% und der optimale Vanadin-, Niob-, Tantal-, Zirkon- und Hafnium-Gehalt bei 1 bis 20 At.%. Die Zugabe dieser Elemente steigert die Schichthärte in einem Konzentrationsbereich, wo überwiegend kubische Phase vorliegt und reduziert dabei im Allgemeinen die abzustimmen, wobei auf Erfahrungswerte mit Ruthenium-freien Schichten zurückgegriffen werden kann.

In einer bevorzugten Ausführungsform weist die Ruthenium-haltige Schicht bzw. Schichtlage außer Aluminium und Titan keine weiteren metallischen Elemente auf.

Der erfinderische Vorteil der Ruthenium Zugabe ist sowohl bei Nitriden als auch bei Karbonitriden festzustellen. Bei Karbonitriden kann der Stickstoffgehalt durch bis zu 20 At.% Kohlenstoff ersetzt werden. In einer bevorzugten Ausführungsform ist $0,9 \leq a \leq 1$. Die besten Resultate konnten mit stöchiometrischen Nitridschichten erzielt werden (a = 1).

Wie bereits erwähnt, ist kubisches Gitter die dominante Kristallstruktur. Dominant bedeutet dabei, dass der Anteil kubischer Phase bei größer 50 % liegt. Neben kubischer Phase können jedoch geringfügige Anteile an Röntgenamorpher und hexagonaler Phasen auftreten, ohne dass die erfinderischen Vorteile wesentlich gemindert werden.

Besonders bewährt hat es sich, wenn die erfindungsgemäße Hartstoffschicht in Form einer Mehrlagenschicht ausgeführt ist. Bevorzugt wechselt dabei eine Ruthenium-haltige Schicht mit einer Ruthenium-freien Schicht ab.

In einer weiteren bevorzugten Ausführungsform weist die Ruthenium-haltige Schicht einen Ruthenium-Gehalt von $0,005 \leq z \leq 0,05$ auf. Der Aluminium-Gehalt beträgt $0,62 \leq x \leq 0,72$, der Titan-Gehalt $0,27 \leq y \leq 0,39$. Die Ruthenium freie Schicht weist einen Aluminium- und einen Titan-Gehalt von $0,45 \leq x,y \leq 0,55$ auf.

Die besten Resultate konnten erzielt werden, wenn die Dicke der einzelnen Schichtlagen 5 bis 30 Nanometer beträgt. Die Ruthenium-freie Zwischenschicht ist wiederum bevorzugt kubisch, wobei die kubische Phase durch ein Al- zu Ti-Verhältnis von 0,8 bis 2 und/oder durch Einstellung der Prozessparameter erreicht werden kann. Bei den Prozessparametern ist wiederum die Biasspannung hervorzuheben, wobei hier ein Wert von < -40 Volt zu bevorzugen ist. Durch die kubische Ruthenium-freie Zwischenschicht ist es möglich, in der Ruthenium-haltigen Schicht den Aluminium-Gehalt zu erhöhen, ohne dass der Anteil an hexagonaler Phase unzulässig hoch wird.

Wie in den Beispielen näher ausgeführt, wird gemäß bevorzugter Ausführungsformen die erfindungsgemäße Schicht auf kubischem Bornitrid oder Hartmetall abgeschieden. Es können dabei die üblichen Haftvermittlungsschichten, wie beispielsweise TiN, und Deckschichten, wie beispielsweise Aluminium-Oxid oder Aluminium-Mischoxide verwendet werden. Für Drehwerkzeuge beträgt die bevorzugte Schichtstärke 3 bis 14 $\mu$m und der Ruthenium-Gehalt $0,01 \leq z \leq 0,06$. Für Fräswerkzeuge beträgt die bevorzugte Schichtstärke 2 bis 8 $\mu$m und der Ruthenium-Gehalt $0,005 \leq z \leq 0,02$.

Als bevorzugte Abscheideverfahren sind PVD-Verfahren, und hier wiederum plasmaunterstützte Gasphasen-Schichtabscheideverfahren, wie beispielsweise Magnetron-Sputtern, Electron Evaporation, Ion Plating oder laserunterstützte PVD-Prozesse zu nennen. Auch Arc-Verdampfungsverfahren sind geeignet, im Speziellen auch im Entwicklungsbereich zur Bestimmung optimaler Schichtzusammensetzungen. Die in der Schicht abgeschiedenen metallischen Elemente liegen dabei in deren Zusammensetzung im Allgemeinen sehr nah an der Zusammensetzung des verwendeten Target-Werkstoffes.

In den folgenden Beispielen wird daher konsequenterweise die Zusammensetzung der erfindungsgemäßen Schicht durch die Target-Zusammensetzung definiert.

Figur 1 zeigt dabei die Standzeit im Längs-Drehversuch von Hartmetallproben. Das Standzeitende ist mit einer Verschleißbreite an der Hauptschneide von 0,2 mm spezifiziert.

Figur 2a zeigt das Verschleißerscheinungsbild nach Längs-Drehversuchen (Warmarbeitsstahl W300) mit einer unbeschichteten c-BN-Probe (Stand der Technik) nach einer Einsatzzeit von 13 min.

Figur 2b zeigt das Verschleißerscheinungsbild nach Längs-Drehversuchen (Warmarbeitsstahl W300) mit einer erfindungsgemäß beschichteten c-BN-Probe nach einer Einsatzzeit von 13 min.

Figur 2c zeigt das Verschleißerscheinungsbild nach Längs-Drehversuchen (Warmarbeitsstahl W300) mit einer erfindungsgemäß beschichteten c-BN-Probe nach einer Einsatzzeit von 19 min.

Figur 3 zeigt die Verschleißbreite versus Einsatzzeit für Längs-Drehversuche (Grauguss GG25) mit unbeschichteten und erfindungsgemäß beschichteten c-BN Proben.

Figur 4 zeigt die Standzeit von Hartmetall-Fräswerkzeugen. Das Standzeitende ist mit einer Verschleißbreite an der Hauptschneide von 0,3 mm spezifiziert.

Beispiel 1

Es wurden Hartmetallschneideinsätze der Zusammensetzung WC, 9,6 Gew.% Co, 7,3 Gew.% Mischkarbide der Type CNMG 120408 EN-TM hergestellt und mittels Arc-Verdampfung mit Schichten versehen, die folgende Zusammensetzung aufweisen:

Probe 1:
Einlagenschicht Al-Ti-N, hergestellt mit einer Target-Zusammensetzung $Al_xTi_y$ mit x = 0,5 und y = 0,5; Schichtdicke = 5,18 $\mu$m (Stand der Technik).

Probe 2:
Al-Ti-N, hergestellt mit einer Target-Zusammensetzung $Al_xTi_y$ mit x = 0,33 und y = 0,67; Schichtdicke = 5,70 $\mu$m (Stand der Technik).

Probe 3:
Al-Ti-N-Viellagenschicht, hergestellt mit einer Target-Zusammensetzung $Al_xTi_y$ mit x = 0,5 und y = 0,5, alternierend mit $Al_xTi_y$ mit x = 0,33 und y = 0,77. Dicke der einzelnen Schichtlagen = 7 nm, Gesamtschichtdicke 4,86 $\mu$m (Stand der Technik).

Probe 4:
Al-Ti-Ru-N haltige Viellagenschicht, hergestellt mit der Target-Zusammensetzung $Al_xTi_yRu_z$ mit x = 0,67, y = 0,32 und z = 0,01, alternierend mit $Al_xTi_y$ mit x = 0,5 und y = 0,5; Schichtstärke der Einzellagen = 7 nm, Gesamtschichtstärke = 5,9 $\mu$m (erfindungsgemäß).

Probe 5:

Al-Ti-Ru-N-Viellagenschicht, hergestellt mit der Target-Zusammensetzung $Al_xTi_yRu_z$ mit x = 0,67, y = 0,28 und z = 0,05, alternierend mit $Al_xTi_y$ mit x = 0,5 und y = 0,5; Schichtstärke der Einzellagen = 7 nm, Gesamtschichtstärke = 4,53 $\mu$m (erfindungsgemäß).

Die Proben wurden dabei in einer produktionstauglichen PVD-Anlage des Typs Oerlikon Balzers RCS hergestellt. Die verwendeten Ruthenium-haltigen Sputtertargets wurden pulvermetallurgisch hergestellt. Die erfindungsgemäßen Viellagenschichten wurden durch den Austausch eines Targets durch ein Target mit erfindungsgemäßer Zusammensetzung bei ansonsten gleichen Prozessparametern hergestellt. Die verwendeten Proben wurden jeweils an gleichen Positionen im Beschichtungsreaktor positioniert.

Die Proben 1 bis 5 wurden danach einem vergleichenden Zerspanungstest unterzogen. Es handelte sich dabei um kontinuierliches Längsdrehen von Ck60 Stahl (DIN 1.1221) unter Einsatz einer Kühl-Schmier-Emulsion und einer Schnittgeschwindigkeit $v_c$ = 200 m/min, einem Vorschub f = 0,25 mm/U und einer Zustelltiefe ap = 2 mm. Als Abbruchkriterium wurde eine Verschleißbreite von 0,2 mm spezifiziert.

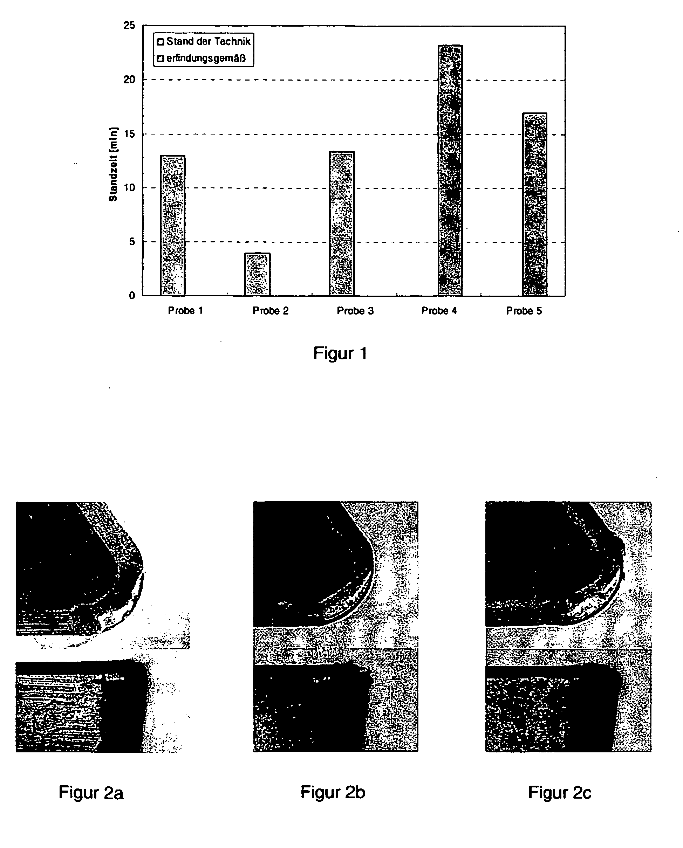

Wie Figur 1 anschaulich dokumentiert weisen die erfindungsgemäßen Proben 4 und 5 eine überlegene Verschleißfestigkeit auf.

Beispiel 2

Hartmetallwendeschneidplatten der Type DCMW 11T304 mit Schneideinsätzen aus kubischem Bornitrid wurden mit einer erfindungsgemäßen Schicht gemäß Probe 4 in Beispiel 1 versehen und mit unbeschichteten Einsätzen verglichen. In einem ersten Versuch wurde der Warmarbeitsstahl W 300 (DIN 1.2343) trocken zerspant. Die Schnittgeschwindigkeit $v_c$ betrug 200 m/min, der Vorschub f 0,05 mm und die Zustelltiefe 0,3 mm.

In einem zweiten Versuch wurde Grauguss der Sorte GG 25 (DIN 0.6025) ebenfalls trocken zerspant. Die Schnittgeschwindigkeit $v_c$ betrug 350 m/min, der Vorschub f 0,2 mm und die Zustelltiefe 1,0 mm.

Wie Figur 2 wiederum anschaulich dokumentiert, weist die erfindungsgemäße Probe (Figur 2b,c) ein deutlich günstigeres Kolk-Verhalten auf. Es wird damit eine signifikante Standzeiterhöhung gegenüber dem unbeschichteten Hartstoff c-BN (Figur 2a) erreicht.

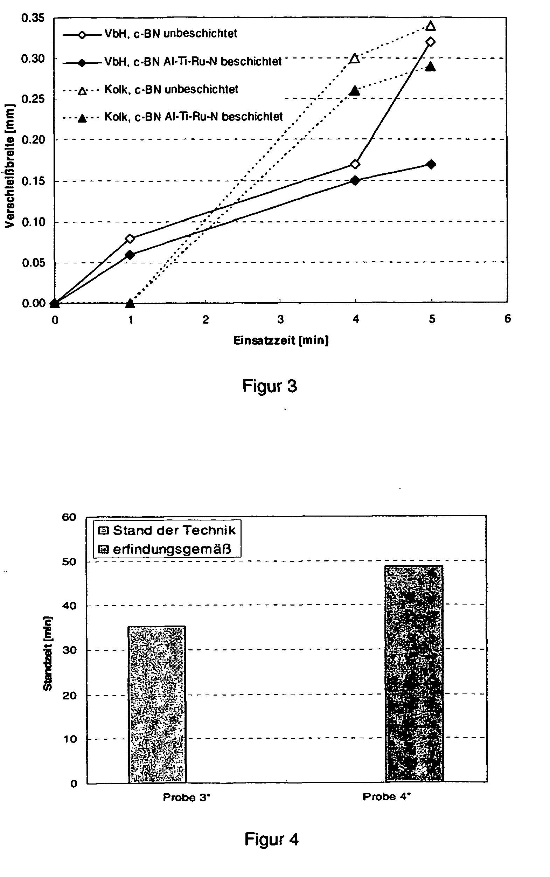

Wie Figur 3 zeigt, werden bei der erfindungsgemäßen Probe im Zerspanungsversuch mit GG 25 sowohl der Verschleiß der Freifläche der Hauptschneide (VbH), als auch der Verschleiß an der Spanfläche, der so genannte Kolk-Verschleiß, reduziert.

Figur 3 dokumentiert hiermit, dass die erfindungsgemäße Ruthenium-haltige Schicht auf einem kubischen Bor-Nitrid-Substratmaterial abgeschieden, eine signifikante Standzeiterhöhung gegenüber einer unbeschichteten Probe bewirkt.

Beispiel 3

Hartmetallschneideinsätze der Zusammensetzung WC, 9,0 Gew.% Co, 4,0 Gew. Mischkarbide der Type SEKN 1203AFSN wurden mit einer erfindungsgemäßen Schicht gemäß Probe 4 in Beispiel 1 und einer Stand der Technik Schicht (Probe 3 in Beispiel 1) versehen und einem vergleichenden Zerspanungstest unterzogen.

Dazu wurde ein 42CrMo4 Stahl (1.7225) mit einer Festigkeit von 1100 MPa mit einem Fräswerkzeug mit einem Durchmesser von 160 mm trocken mit einer Schnittgeschwindigkeit $v_c$ von 230 m/min, einem Vorschub pro Zahn $f_z$ von 0,3 mm und einer Zustellung $a_p$ von 2 mm im Einzahnverfahren im Gleichlauf zerspant. Das Abbruchkriterium für die Zerspanungsversuche wurde mit 0,3 mm Verschleißbreite an der Freifläche der Hauptschneide festgelegt.

Wie Figur 4 zeigt, konnte auch hier eine signifikante Verbesserung des Standzeitverhaltens der erfindungsgemäß beschichteten Probe im Vergleich zur Stand der Technik Probe erzielt werden.

Beispiel 4

Hartmetallschneideinsätze der Zusammensetzung WC, 9,0 Gew.% Co, 4,0 Gew. Mischkarbide der Type SEKN 1203AFSN wurden mit einer erfindungsgemäßen Viellagenschicht beschichtet, wobei eine Ruthenium-freie Schicht mit der Target-Zusammensetzung $Al_xTi_y$ mit x = 0,5 und y = 0,5 hergestellt wurde. Die Zusammensetzung der Ruthenium-haltigen Schicht ist in der Tabelle 1 wiedergeben. Die Schichtstärke der Einzellagen betrug 7 nm, die Gesamtschichtstärke 5,2 $\pm$ 0,8 $\mu$m. Die beschichteten Proben wurden einem vergleichenden Zerspanungstest gemäß Beispiel 3 unterzogen.

Tabelle 1

| Zusammensetzung | | | | | Standzeit [min.] |
|---|---|---|---|---|---|
| x | y | z | v | a | |
| 0,67 | 0,32 | 0,01 | 0 | 0,9 | 43 |
| 0,67 | 0,27 | 0,01 | 0,005 B | 1 | 48 |
| 0,67 | 0,27 | 0,01 | 0,05 Cr | 1 | 43 |
| 0,67 | 0,22 | 0,01 | 0,1 V | 1 | 49 |
| 0,67 | 0,22 | 0,01 | 0,1 Ta | 1 | 48 |
| 0,67 | 0,22 | 0,01 | 0,1 Zr | 1 | 44 |

Die Standzeitwerte aus Tabelle 1 zeigen, dass anwendungsspezifisch durch das Zulegieren weiterer metallischer Komponenten eine Verbesserung der Schichteigenschaften erreicht werden kann. Da das Zulegieren jedoch mit einem Abfall der Duktilitätswerte verbunden sein kann und der Einfluss der Duktilitätseigenschaften auf das Standzeitverhalten sehr anwendungsspezifisch ist, hängt die Auswahl des Legierungselementes und des Gehaltes vom jeweiligen Anwendungsfall ab.

**Patentansprüche**

1. Ein- oder mehrlagige nitridische oder karbonitridische Hartstoffschicht, die Al und Ti enthält,
   **dadurch gekennzeichnet,**
   **dass** zumindest eine Schichtlage die Zusammensetzung $(Al_xTi_yRu_zMe_v)(N_aC_{1-a})$ aufweist, mit
   $0,45 \leq x \leq 0,75$
   $0,2 \leq y \leq 0,55$
   $0,001 \leq z \leq 0,1$
   $0 \leq v \leq 0,2$
   $0,9 \leq (x + y + z + v) \leq 1,1$
   $0,8 \leq a \leq 1,0$;
   wobei Me ein oder mehrere Elemente der Gruppe Si, B, W, Mo, Cr, Ta, Nb, V, Hf, Zr und v der Summengehalt dieser Elemente ist.

2. Hartstoffschicht nach Anspruch 1, **dadurch gekennzeichnet, dass** $x + y + z + v = 1$.

3. Hartstoffschicht nach Anspruch 1 oder 2, **dadurch gekennzeichnet, dass** $v = 0$.

4. Hartstoffschicht nach Anspruch 1 oder 2, **dadurch gekennzeichnet, dass**
   $0,001 \leq v \leq 0,01$ für Si, B
   $0,01 \leq v \leq 0,1$ für Cr, Mo, W
   $0,01 \leq v \leq 0,2$ für V, Nb, Ta, Zr, Hf

5. Hartstoffschicht nach einem der Ansprüche 1 bis 4, **dadurch gekennzeichnet, dass** $0,9 \leq a \leq 1$.

6. Hartstoffschicht nach Anspruch 5, **dadurch gekennzeichnet, dass** $a = 1$.

7. Hartstoffschicht nach einem der Ansprüche 1 bis 6, **dadurch gekennzeichnet, dass** die dominante Kristallstruktur kubisch ist.

8. Hartstoffschicht nach einem der Ansprüche 1 bis 7, **dadurch gekennzeichnet, dass** $0,005 \leq z \leq 0,06$

9. Hartstoffschicht nach einem der Ansprüche 1 bis 8, **dadurch gekennzeichnet, dass** diese mehrlagig ausgeführt ist.

10. Hartstoffschicht nach Anspruch 9, **dadurch gekennzeichnet, dass** sich Schichtlagen mit $0,001 \leq z \leq 0,1$ mit Schichtlagen mit $z = 0$ abwechseln.

**11.** Hartstoffschicht nach Anspruch 10, **dadurch gekennzeichnet, dass** sich Schichtlagen mit

$0{,}62 \leq x \leq 0{,}72$

$0{,}27 \leq y \leq 0{,}39 \quad 0{,}005 \leq z \leq 0{,}05$

$v = 0$

mit Schichtlagen mit

$0{,}45 \leq x \leq 0{,}55$

$0{,}45 \leq y \leq 0{,}55$

$z = 0$

$v = 0$

abwechseln.

**12.** Hartstoffschicht nach einem der Ansprüche 9 bis 11, **dadurch gekennzeichnet, dass** die Schichtlagenstärke 5 bis 30 nm beträgt.

**13.** Hartstoffschicht nach einem der Ansprüche 9 bis 12, **dadurch gekennzeichnet, dass** die Kristallstruktur der Schichtlage mit z = 0 kubisch ist.

**14.** Verwendung einer Hartstoffschicht nach einem der Ansprüche 1 bis 13 zur Beschichtung von kubischem Bomitrid.

**15.** Verwendung einer Hartstoffschicht nach einem der Ansprüche 1 bis 13 zur Beschichtung von Hartmetall.

**16.** Drehwerkzeug mit einer Hartstoffschicht nach einem der Ansprüche 1 bis 9, **dadurch gekennzeichnet, dass** $0{,}01 \leq z \leq 0{,}06$ und die Schichtstärke 3 bis 14 $\mu$m betragen.

**17.** Fräswerkzeug mit einer Hartstoffschicht nach einem der Ansprüche 1 bis 9, **dadurch gekennzeichnet, dass** $0{,}005 \leq z \leq 0{,}02$ und die Schichtstärke 2 bis 8 $\mu$m betragen.

**18.** Verfahren zur Herstellung einer Hartstoffschicht nach einem der Ansprüche 1 bis 13, **dadurch gekennzeichnet, dass** diese mittels PVD abgeschieden wird.

**Claims**

**1.** Single-layer or multilayer nitridic or carbonitridic hard material coating containing Al and Ti, **characterized in that** at least one coating layer has the composition

$(Al_x Ti_y Ru_z Me_v) (N_a C_{1-a})$, where

$0.45 \leq x \leq 0.75$;

$0.2 \leq y \leq 0.55$;

$0.001 \leq z \leq 0.1$;

$0 \leq v \leq 0.2$

$0.9 \leq (x + y + z + v) \leq 1.1$

$0.8 \leq a \leq 1.0$;

where Me is one or more elements from the group consisting of Si, B, W, Mo, Cr, Ta, Nb, V, Hf, Zr and v is the total content of these elements.

**2.** Hard material coating according to Claim 1, **characterized in that** x + y + z + v = 1.

**3.** Hard material coating according to Claim 1 or 2, **characterized in that** v = 0.

**4.** Hard material coating according to Claim 1 or 2, **characterized in that**

$0.001 \leq v \leq 0.01$ for Si, B

$0.01 \leq v \leq 0.1$ for Cr, Mo, W

$0.01 \leq v \leq 0.2$ for V, Nb, Ta, Zr, Hf.

**5.** Hard material coating according to any of Claims 1 to 4, **characterized in that** $0.9 \leq a \leq 1$.

**6.** Hard material coating according to Claim 5, **characterized in that** a = 1.

**7.** Hard material coating according to any of Claims 1 to 6, **characterized in that** the dominant crystal structure is cubic.

**8.** Hard material coating according to any of Claims 1 to 7, **characterized in that** $0.005 \le z \le 0.06$.

**9.** Hard material coating according to any of Claims 1 to 8, **characterized in that** it has a multilayer structure.

**10.** Hard material coating according to Claim 9, **characterized in that** layers in which $0.001 \le z \le 0.1$ alternate with layers in which $z = 0$.

**11.** Hard material coating according to Claim 10, **characterized in that** layers in which
$0.62 \le x \le 0.72$
$0.27 \le y \le 0.39$
$0.005 \le z \le 0.05$
$v = 0$
alternate with layers in which
$0.45 \le x \le 0.55$
$0.45 \le y \le 0.55$
$z = 0$
$v = 0$.

**12.** Hard material coating according to any of Claims 9 to 11, **characterized in that** the layer thickness is from 5 to 30 nm.

**13.** Hard material coating according to any of Claims 9 to 12, **characterized in that** the crystal structure of the layer in which $z = 0$ is cubic.

**14.** Use of a hard material coating according to any of Claims 1 to 13 for coating cubic boron nitride.

**15.** Use of a hard material coating according to any of Claims 1 to 13 for coating cemented carbide.

**16.** Turning tool having a hard material coating according to any of Claims 1 to 9, **characterized in that** $0.01 \le z \le 0.06$ and the coating thickness is from 3 to 14 $\mu$m.

**17.** Milling tool having a hard material coating according to any of Claims 1 to 9, **characterized in that** $0.005 \le z \le 0.02$ and the coating thickness is from 2 to 8 $\mu$m.

**18.** Process for producing a hard material coating according to any of Claims 1 to 13, **characterized in that** it is deposited by means of PVD.


**Revendications**

**1.** Revêtement dur monocouche ou multicouches de nitrures ou carbonitrures, contenant Al et Ti, **caractérisé par** au moins une couche dont la composition répond à la formule $(Al_xTi_yRu_zMe_v)(N_aC_{1-a})$ dans laquelle
$0,45 \le x \le 0,75$
$0,2 \le y \le 0,55$
$0,001 \le z \le 0,1$
$0 \le v \le 0,2$
$0,9 \le (x+y+z+v) \le 1,1$
$0,8 \le a \le 1,0$
Me désignant un ou plusieurs éléments du groupe Si, B, W, Mo, Cr, Ta, Nb, V, Hf, Zr et v désignant la teneur cumulée de ces éléments.

**2.** Revêtement dur selon la revendication 1, **caractérisé en ce que** $x + y + z + v = 1$.

**3.** Revêtement dur selon la revendication 1 ou 2, **caractérisé en ce que** $v = 0$

**4.** Revêtement dur selon revendication 1 ou 2, **caractérisé en ce que**
$0,001 \le v \le 0,01$ pour Si, B

$0,01 \le v \le 0,1$ pour Cr, Mo, W
$0,01 \le v \le 0,2$ pour V, Nb, Ta, Zr, Hf

5. Revêtement dur selon l'une quelconque des revendications 1 à 4, **caractérisé en ce que** $0,9 \le a \le 1$.

6. Revêtement dur selon revendication 5, **caractérisé en ce que** a = 1.

7. Revêtement dur selon l'une quelconque des revendications 1 à 6, **caractérisé en ce que** la structure cristalline dominante est la forme cubique.

8. Revêtement dur selon l'une quelconque des revendications 1 à 7, **caractérisé en ce que** $0,005 \le z \le 0,06$.

9. Revêtement dur selon l'une quelconque des revendications 1 à 8, **caractérisé en ce qu'**il est multicouches.

10. Revêtement dur selon revendication 9, **caractérisé par le fait que** des couches où $0,001 \le z \le 0,1$ alternent avec des couches où z = 0.

11. Revêtement dur selon revendication 10, **caractérisé par le fait que** des couches où :

$0,62 \le x \le 0,72$
$0,27 \le y \le 0,39$
$0,005 \le z \le 0,05$
v = 0
alternent avec des couches où :
$0,45 \le x \le 0,55$
$0,45 \le y \le 0,55$
z = 0
v = 0

12. Revêtement dur selon l'une quelconque des revendications 9 à 11, **caractérisé par** une épaisseur de couches allant de 5 à 30 nm.

13. Revêtement dur selon l'une quelconque des revendications 9 à 12, **caractérisé par le fait que** la structure cristalline de la couche où z = 0 est de forme cubique.

14. Application d'un revêtement dur suivant l'une des revendica.tions 1 à 13 au dépôt de nitrure de base cubique.

15. Application d'un revêtement dur suivant l'une quelconque des revendications 1 à 13 au dépôt d'un revêtement de métal dur.

16. Outil rotatif à revêtement dur suivant l'une quelconque des revendications 1 à 9, **caractérisé en ce que** $0,01 \le z \le 0,06$ et **en ce que** l'épaisseur de couches est comprise entre 3 et 14 $\mu$m.

17. Fraise à revêtement dur suivant l'une quelconque des revendications 1 à 9, **caractérisé en ce que** $0,005 \le z \le 0,02$ et **en ce que** l'épaisseur de couches est comprise entre 2 et 8 $\mu$m.

18. Procédé de réalisation d'un revêtement dur suivant l'une quelconque des revendications 1 à 13, **caractérisé en ce que** l'on opère par dépôt par pulvérisation sous vide (PVD).

Figur 1

Figur 2a          Figur 2b          Figur 2c

Figur 3

Figur 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2644710 B
- US 5558653 A
- JP 8199340 A
- JP 8199341 A
- DE 3611492